Europäisches Patentamt

European Patent Office

Office européen des brevets

(19)

(11) Publication number: **0 482 215 A1**

## EUROPEAN PATENT APPLICATION
### published in accordance with Art. 158(3) EPC

(21) Application number: 91908865.8

(22) Date of filing: **14.05.91**

(86) International application number:
**PCT/JP91/00633**

(87) International publication number:
**WO 91/18422 (28.11.91 91/27)**

(51) Int. Cl.⁵: **H01L 35/34**

(30) Priority: **14.05.90 JP 123398/90**

(43) Date of publication of application:
**29.04.92 Bulletin 92/18**

(84) Designated Contracting States:
**DE FR GB**

(71) Applicant: **KABUSHIKI KAISHA KOMATSU SEISAKUSHO**
**3-6, Akasaka 2-chome**
**Minato-ku Tokyo 107(JP)**
Applicant: **KOMATSU ELECTRONICS INC.**
**2597, Shinomiya**
**Hiratsuka-shi, Kangawa 254(JP)**

(72) Inventor: **YAMASHITA, Masao, Kabushiki Kaisha Komatsu**
Seisakusho Research Insti tution;
**1200, Manda, Hiratsuka-shi; Kanagawa 254(JP)**
Inventor: **IMAIZUMI, Hisaakira, Kabushiki Kaisha Komatsu**
Seisakusho Research Insti tution;
**1200, Manda, Hiratsuka-shi; Kanagawa 254(JP)**
Inventor: **MORI, Yukoh, 76-2, Fukuura Yugawara-machi**
**Ashigarashimo-gun**
**Kanagawa 259-03(JP)**

(74) Representative: **Selting, Günther, Dipl.-Ing. et al**
**Deichmannhaus am Hauptbahnhof**
**W-5000 Köln 1(DE)**

(54) **METHOD OF MANUFACTURING THERMOELECTRIC DEVICE.**

(57) This method is characterized in that the thermoelectric elements of a thermoelectric device are made by forming solder plating layers (3) on the surfaces of P- and N-type semiconductors (10a and 10b) each having the Peltier effect, and then by cutting the semiconductors into pieces of desired shapes.

FIG. 3 (a)

10a

FIG. 3 (b)

2

10a

FIG. 3 (c)

3 (SOLDER PLATING)

FIG. 3 (d)

2

3

10

2

FIG. 3 (e)

4b

2

5

6

FIG. 3 (f)

3a 2

I

FIG. 3 (g)

4b

10a

10b

2

6

2

5

4a

## TECHNICAL FIELD OF THE INVENTION

This invention relates to methods of making thermoelectric apparatus, and more particularly to a method of forming electrodes of a thermoelectric element couple of the apparatus.

## BACKGROUND ART

A thermoelectric element composed of a PN element couple formed by joining a P-type semiconductor and an N-type semiconductor together with a metal interposed therebetween, which utilizes so called Peltier effect in which one end of the couple is heated while the other end is cooled down according to a direction of a current flowing through the junction thereof, has been expected for use in various devices such as a portable cooler, since the thermoelectric element is simple in structure and small in size.

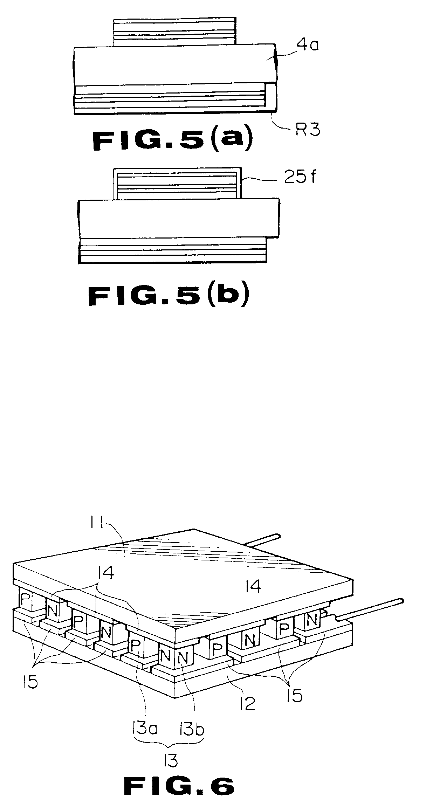

For example, as shown in Fig. 6, a thermomodule formed by integrating a plurality of such thermoelectric elements is configured such that a plurality of PN element couples 13 are sandwiched between a first and a second heat exchange substrates 11 and 12 of an insulating substrate having a high thermal conductivity such as a ceramics substrate so as to have a high thermal contactivity to the substrates 11 and 12, and each element couple 13 is connected in series with a first and a second electrodes 14 and 15.

The first and the second electrodes 14 and 15 that are usually made of a copper plate so as to endure a large electric current flowing therethrough are fixed on a conductor layer pattern formed on the surfaces of the heat exchange substrates 11 and 12 through a melting layer such as a solder.

Further, P-type thermoelectric elements 13a and N-type thermoelectric elements 13b are alternately fixed in pairs on the first and the second electrodes through the solder layer to form the PN element couples 13 as being connected in series.

In order to increase the heat exchange efficiency, it is necessary to configure the heat exchange substrate with an insulating material having a high thermal conductivity, and also in order to prevent the deterioration due to thermal distortion, a thermal expansion coefficient of the material should be small.

Recently, in addition to the conventionally used alumina ceramics substrates or beryllia ceramics substrates, aluminum nitride ceramics substrates or silicon carbide ceramics substrates have been also proposed as materials for the heat exchange substrate. Among these materials, the silicon carbide ceramics has the thermal conductivity of $2.7W\ cm^{-1}K^{-1}$, that is, more than nine times as high as alumina, and has the thermal expansion coefficient of $3.7\times10^{-7}K^{-1}$, that is, half as small as the coefficient of alumina ceramics. Therefore, a thermoelectric apparatus using the silicon carbide ceramics as the heat exchange substrate material is not damaged by a change in temperature. Thus, a reliable thermoelectric apparatus having a high heat exchange efficiency can be obtained.

In such a thermoelectric apparatus structure, it has been proposed to configure the electrodes by a thick film conductor layer pattern formed on the surface of the heat exchange substrate in order to improve the assembly efficiency in the positioning and fixation of the electrodes to the heat exchange substrate.

According to the thermoelectric apparatus having such a configuration as described above, since the positioning and fixation of the electrode plates to the conductor pattern on the heat exchange substrate are unnecessary and the overall process is greatly simplified, any misalignment of the conductor pattern and the electrodes does not occur and thus the reliability of the apparatus can be enhanced.

When the thermoelectric elements are fixed on the heat exchange substrate through a solder, a process is employed in which a preliminary solder is formed on the thermoelectric elements as well as on the electrode pattern of the heat exchange substrates for fixing purposes.

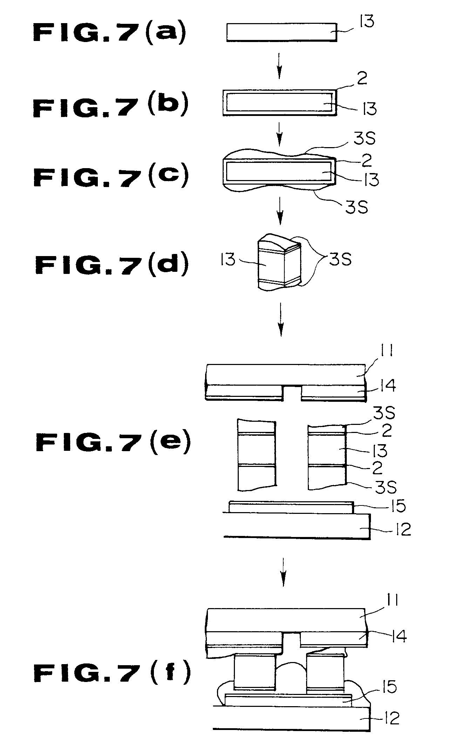

To form the solder layer on such thermoelectric elements, the conventionally practiced method is that first slicing a material 13 (FIG. 7(a)), forming a nickel plated layer 2 on the surface of the sliced material for preventing the element diffusion (FIG. 7(b)), and forming a solder layer 3S on the nickel plated layer 2 by rubbing on a heated plate being wet with solder, or by applying a solder by hand with use of a soldering iron (FIG. 7(c)), and dividing the resulting material (FIG. 7(d)).

However, it is extremely difficult to apply an uniform quantity of solder as shown.

Although a method of applying paste-like cream solder with use of a dispenser or by a printing method has been proposed, the number of solder compositions is limited with the solders on the market. Thus, the solder composition cannot be selected arbitrarily. When such thermoelectric elements are fixed on the electrode patterns 14 and 15 of the heat exchange substrates 11 and 12 (FIG. 7(e)), and if the solder coating is too thick, an electrical/thermal short circuit occurs due to deposition of possible excess solder. If the solder coating is too thin, an electrical/thermal contact resistance between the elements and the electrodes increases. Furthermore, if condensed moisture enters into gaps between the elements and the electrodes and freezes when the apparatus is electrified, the junction is damaged. The problem that the elements are unbalanced or irregular in height may be an extreme obstacle to automatic mounting.

As just described above, the method of rubbing the sliced surface on the heated plate is apt to be a cause of lowering the assembling yield since it is difficult to equally apply the solder.

Besides, the method of applying a solder by hand with use of a soldering iron has the problems that it is unsuitable for mass production since it requires skillfulness and many processing steps and that it is difficult to apply the solder equally. Especially, when the solder having a high melting point is used, the working efficiency is lowered.

Concerning the method using a cream solder, the solder composition is limited, and the solder having a high melting point or any optional composition cannot be selected. A recent trend is that the solder having a high melting point is required by some users to raise the heat-resistant limit temperature of the apparatus.

## SUMMARY OF THE INVENTION

In view of the above, it is an object of the present invention to easily form thermoelectric elements with a uniform solder layer and to provide a thermoelectric apparatus with a high reliability and suitable for mass production.

In the present invention, the thermoelectric elements of the thermoelectric apparatus are formed by first forming a solder plated layer on each surface of P and N type semiconductors having Peltier effect and then cutting each semiconductor into a required shape.

The solder plating process is characterized by forming a solder plated layer having a composition including as main solder components, tin (Sn): 70-99.95% and antimony (Sb): 0.05-30% on each surface of the P and N type semiconductors.

Alternatively, it is characterized by forming a solder plated layer having a composition including, as main components, tin (Sn): 10-99.8% and lead (Pb): 0.2-90% on each surface of the P and N type semiconductors.

It is characterized by forming a solder plating layer having a composition including, as main components, tin (Sn): 60-99.9% and copper (Cu): 0.01-40% on each surface of the P and N type semiconductors.

It is characterized by forming a solder plated layer having a composition including, as main components, tin (Sn): 95-99.9% and germanium (Ge): 0.1-5% on each surface of the P and N type semiconductors.

It is characterized by forming a solder plated layer having a composition including, as main components, lead (Pb): 59-95% and indium (In): 5-50% on each surface of the P and N type semiconductors.

According to the above method, since the thermal electric elements are formed by first forming a solder plated layer on each surface of the P and N type semiconductors having Peltier effect, and then cutting each semiconductor into a required shape, the solder layer having a uniform thickness can be very easily obtained.

A thermoelectric apparatus having a high junction strength and stable characteristics can be obtained when the solder plated layer having the composition including, as the main components, tin (Sn): 70-99.95% and antimony (Sb): 0.05-30% is used. If antimony content is lower than 0.05%, the solder strength gets lower. If it is more than 30%, the wettability of the solder gets lower and the range of solidifying temperature becomes excessively wide which causes segregation, and as a result, the quality becomes unstable.

Alternatively, a thermoelectric apparatus having a high junction strength and stable characteristics can be obtained when the solder plated layer having the composition including, as the main components, tin (Sn): 10-99.8% and lead (Pb): 0.2-90% is used. If the proportion of the lead content is lower than 0.2%, the solder strength gets lower. If it is more than 90%, the wettability gets lower.

Alternatively, a thermoelectric apparatus having a high junction strength and stable characteristics can be obtained when the solder plated layer having the composition including, as the main components, tin (Sn): 60-99.9% and copper (Cu): 0.01-40% is used. If copper content is lower than 0.01%, the solder strength gets lower. If it is more than 40%, the wettability of solder gets lower and the range of solidifying temperature becomes excessively wide which causes segregation, and as the result, the quality becomes unstable.

Alternatively, a thermoelectric apparatus having a high junction strength and stable characteristics can be obtained when the solder plated layer having the composition including,as the main components, tin (Sn): 95-99.9% and germanium (Ge): 0.1-5% is used. If germanium content is lower than 0.1%, the solder strength gets lower. If it is more than 5%, the wettability of solder gets lower and the range of solidifying temperature becomes excessively wide which causes segregation, and as a result, the quality becomes unstable.

Alternatively, a thermoelectric apparatus having a high junction strength and stable characteristics can be obtained when the solder plated layer having the composition including, as the main components, lead (Pb): 50-95% and indium (In): 5-50% is used. If indium content is lower than 5%, the wettability of the solder gets lower. If it is more than 50%, the solder strength gets lower.

## BRIEF DESCRIPTION OF THE DRAWINGS

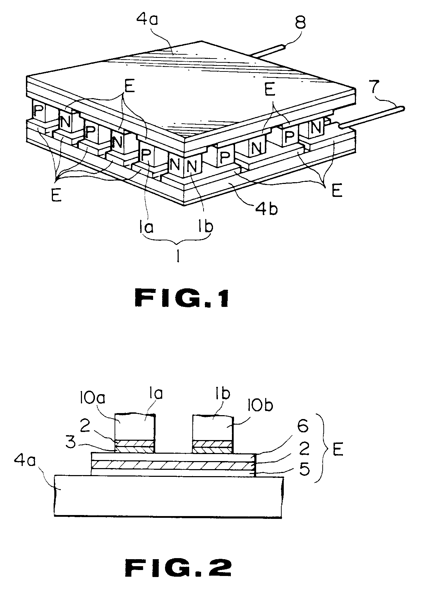

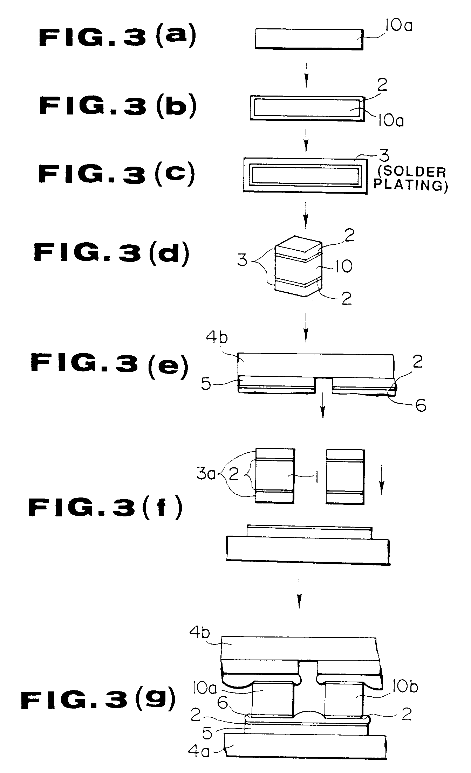

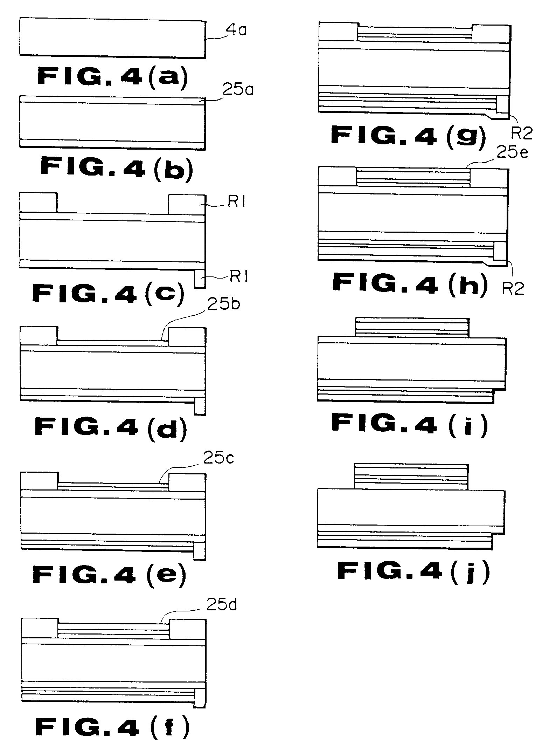

FIG. 1 shows a thermoelectric apparatus as an embodiment of the present invention; FIG. 2 is an enlarged sectional view of the essential portion of the apparatus; FIGS. 3(a)-3(h) show the steps of making the thermoelectric apparatus; FIGS. 4(a)-4(J) show the steps of making a heat exchange substrate of the thermoelectric apparatus as a second embodiment of the present invention; FIGS. 5(a)-5(b) show a part of modifications of the steps of making the thermoelectric apparatus; FIG. 6 shows a conventional thermoelectric apparatus; and FIGS. 7 (a)-7(f) show the steps of making the conventional thermoelectric elements.

## BEST MODE FOR CARRYING OUT THE INVENTION

Examples of the present invention will be described hereinafter in more detail with respect to the drawings.

[Example 1]:

FIG. 1 shows the appearance of a thermoelectric apparatus as an example of the present invention, and FIGS. 2(a) and 2(b) are enlarged sectional views of the essential portion of the thermoelectric apparatus.

The thermoelectric apparatus uses conventional alumina ceramics substrates as a first and a second heat exchange substrates 4a and 4b.

The thermoelectric elements include a nickel plated layer 2 and a 60Sn-40Pb solder plated layer 3 formed on both the end surfaces of P type and N type Bi-Te semiconductor substrates 1a, 1b, as shown in FIG. 2.

Concerning the second heat exchange substrate 4b as shown in FIG. 2. a P type thermoelectric element 10a and an N type thermoelectric element 10b are fixed on a three-layered electrode pattern of a thick copper plated layer 5 having a coating thickness of 200$\mu$m, a nickel plated layer 2 having a coating thickness of 5$\mu$m and a Sn-Pb solder plated layer 6 having a coating thickness of 5$\mu$m. Besides, formed on the other surface is a three-layered electrode pattern E of the thick copper plated layer 5 having a coating thickness of 200 $\mu$m, and the nickel plated layer 2 having a coating thickness of 5$\mu$m and a Sn-Pb solder plated layer 6 having a coating thickness of 5$\mu$m.

A first heat exchange substrate 1 has a structure similar to the second heat exchange substrate 2 although no enlarged view of the essential portion of the substrate 1 is shown.

In this way, the adjoining P and N type thermoelectric elements 1a and 1b are connected by the electrode patterns on the first and second heat exchange substrates 4a, 4b, by solder melting to construct PN element couples 1. These PN element couples are connected in series, and a first electrode lead 7 and a second electrode lead 8 are disposed on the corresponding electrode patterns that are positioned at both ends of the circuit. When the first and the second electrode leads are electrified, for example, the first heat exchange substrate becomes lower in temperature and the second heat exchange substrate becomes higher in temperature.

The following is a description of the method of making the thermoelectric apparatus.

First, the method of making the thermoelectric elements will be described.

A Bi-Te semiconductor wafer 10a containing P type impurities was sliced to a size of 30 x 30 x 0.96t, as shown in FIG. 3(a).

Thereafter, a nickel (Ni) plated layer 2 having a coating thickness of 5 $\mu$m was formed on both surfaces of the slice by the electroless plating as shown in FIG. 3(b).

Then, an Sn-Pb eutectic solder plated layer 3 having a coating thickness of 20 $\mu$m was formed by a sulfonic acid bath, as shown in FIG. 3(c). The composition of the Sn-Pb eutectic solder was Sn 60%-Pb 40%.

Then a P type thermoelectric element 1a sized 0.64 x 0.64 x 0.96t was formed by dicing, as shown in FIG. 3(d).

Similarly, an N type thermoelectric elements 1b sized 0.64 x 0.64 x 0.96t was formed from a Bi-Te semiconductor wafer 1 containing N type impurities as a starting material.

Next, a heat exchange substrate was formed as shown in FIG. 3(e).

A thick copper plated layer 5 having a coating thickness of 200 $\mu$m was formed on a surface of an alumina ($Al_2O_3$ ) substrate 4 sized 8.7 x 8.7 x 0.635t, and patterned by etching. After an electroless nickel plating 2 was performed on the patterned layer in order to prevent the element diffusion and to improve solder adhesion, the resulting semi-finished article was rubbed to a heated plate that was heated to 230°C and wetted with the Sn-Pb eutectic solder (Sn60%-Pb40%) 6. It was then confirmed that the solder was applied on the whole nickel plated surface, and the substrate was then wiped with fluorine rubber to remove the most of solder deposited on the surface.

Sixty-two of P and N type thermoelectric elements 1a, 1b having the solder layers on the electrode surfaces thereof were positioned with a jig (not shown) and mounted automatically on the solder pattern 6 of one of the first and the second heat exchange substrates thus formed, for example, the second heat exchange substrate 2 were heated from the back side (FIG. 3(f)).

Next, the second heat exchange substrate was placed, a weight of 40g was put on the top of the substrate, the whole was heated for 20 minutes in the vapor of Fluorinate having a boiling point of 253°C to fix the low temperature side electrode pattern of the second heat exchange substrate to the P and N type thermoelectric elements (FIG. 3(g)).

Finally, 0.3 $\phi$ electrode leads 7,8 were attached by a small soldering iron.

The thermoelectric apparatus thus formed was highly reliable because the solder had a coating thickness prescribable with high accuracy, as well as spread with high flatness. In addition, the heat exchange substrates and the electrode patterns were closely joined with a high pattern accuracy.

In this way, 8 thermoelectric apparatuses were produced and the lowest temperatures attained were measured under a vacuum of $10^{-5}$ Torr. The result is shown in Table 1 below.

## Table 1

| No. | Lowest temp. attained |
|-----|-----------------------|
|     | ($^o$C) |
| 1 | -38 |
| 2 | -36 |
| 3 | -38 |
| 4 | -38 |
| 5 | -37 |
| 6 | -39 |
| 8 | -37 |

Average -37.9°C

In this case, the bottom of the thermoelectric apparatus was joined to a constant temperature plate of 27°C with 47°C solder for measuring purposes.

It will be seen that although the lowest temperatures attained changed from -36°C to -40°C, they were within the average value ±2°C.

Furthermore, these 8 thermoelectric apparatuses were electrified alternately by changing the polarities in the air so as to repeat a cycle of cooling and heating.

First, when they were cooled by 1.5A X 10min. electrification to about -30°C, the whole surface of the substrate of low temperature side was frosted.

Next, they were heated by 1.5A x 0.8min. electrification, with the polarities changed, so that the substrate of the low temperature side was raised to 10°C-17°C and the frost was fused into water.

Again, when they were cooled by 1.5A x 10min. electrification with the polarities changed, the moisture on the substrate of the low temperature side was again frozen.

After 15 cycles of this process were repeated and the moisture of the thermoelectric apparatus was removed. The lowest temperatures attained were measured under a vacuum of $10^{-5}$ Torr. The result is shown in Table 2 below.

Table 2

| No. | Lowest temp. attained |
|-----|-----------------------|
| 1 | -37  (°C) |
| 2 | -36 |
| 3 | -38 |
| 4 | -38 |
| 5 | -37 |
| 6 | -39 |
| 7 | -39 |
| 8 | -39 |

Average -37.8°C

As is apparent from the result of Table 2, no deterioration in the characteristic of the thermoelectric apparatus caused by a freeze of condensed moisture that entered the gap was recognized.

[Example 2]:

The following is a description of a second example of the present invention.

The composition of the solder used in this example was 98Sn-2Sb of which the melting point was 232°C. The remaining structure was exactly the same as that of the Example 1.

A 98Sn-2Sb solder layer was formed using a sulfuric acid bath when the thermoelectric elements were formed.

The 98Sn-2Sb solder layer was formed on an alumina substrate by rubbing the alumina substrate having a copper plated layer pattern and a nickel plated layer to a heated plate heated to 265 C over which the 98Sn-2Sb solder was spread.

Among other things, measurements were conducted in exactly the same manner as in the Example 1.

In this way, 8 thermoelectric apparatuses were produced and the lowest temperatures attained were measured under a vacuum of $10^{-5}$ Torr. The result is shown in Table 3 below.

Table 3

| No. | Lowest temp. attained |
|-----|-----------------------|
| 21 | -38  (°C) |
| 22 | -39 |
| 23 | -38 |
| 24 | -37 |
| 25 | -38 |
| 26 | -38 |
| 27 | -37 |
| 28 | -40 |

Average -38.1°C

Also, the apparatuses were joined to the corresponding constant temperature plates of 27°C with 47°C solder and measured as in the Example 1.

It will be seen that although the lowest temperatures attained changed from -37°C to -40°C, they were within the average temperature ±2°C.

Furthermore, these 8 thermoelectric apparatuses were electrified alternately changing the polarities in the air so as to repeat the cycle of cooling and heating as in the Example 1. The result is shown in Table 4 below.

Table 4

| No. | Lowest temp. attained (°C) |
|-----|------------------|
| 21 | -38 |
| 22 | -39 |
| 23 | -38 |
| 24 | -37 |
| 25 | -38 |
| 26 | -37 |
| 27 | -37 |
| 28 | -39 |

Average -37.9 °C

As is apparent from the result of Table 4, no deterioration in the characteristic of the thermoelectric apparatus caused by the freeze of condensed moisture that entered the gap was recognized.

[Example 3]:

The following is a description of a third example of the present invention.

The composition of the solder applied in this example was 70Pb-30In of which the melting point was 230°C and solder coating was made by plating to the heat exchange substrates. The other conditions were exactly the same as those of the Example 1.

The formation of the 70Pb-30In solder layer on thermoelectric elements was made using a boric hydrofluoric acid bath.

The electrode pattern on the alumina substrate was formed as follows;

First, one and the other surfaces of each of the alumina ceramics heat exchange substrates 4a and 4b (the second heat exchange substrate only is shown here) are roughed, as shown in the FIG. 4(a).

Thereafter, an electroless copper plated film 25a having a coating thickness of 1-1.5μm was formed on each of the surfaces of the substrates by the electroless copper plating, as shown in FIG. 4(b).

As shown in FIG. 4(c), a dry film was stuck to each of the surfaces of the substrates and patterned by photolithography to form a resist pattern R1 thereon.

As shown in FIG. 4(d), a copper plated film 25b having a coating thickness of 10-100μm was formed selectively on the electroless copper plated film 5a on each surface of the substrates by electrolytic plating or the like using the electroless copper plated film 25a as an electrode.

As shown in FIG. 4(e), a nickel plated layer 25c having a coating thickness of 5μm was formed by electrolytic plating or the like.

As shown in FIG. 4(f), a gold plated layer 25d having a coating thickness of 0.5μm was formed on the top of the layer 25c by electrolytic plating.

As shown in FIG. 4(g), a dry film was stuck to the back side of the resulting half-finished product and patterned to form a resist pattern R2 by photolithography.

Thereafter, as shown in FIG. 4(h), a 70Pb-30In solder plated layer 25e having a coating thickness of 5μm was formed by electrolytic plating or the like.

As shown in FIG. 4(i), the resist patterns R1 and R2 were peeled off to form electrode patterns on the surfaces of the substrates.

As shown in FIG. 4(j), the electroless copper plated layer 25a that was exposed from the solder plated layer and remained slightly on the surface was removed by light etching.

The time for heating in the fluorinate vapor during the assembly was 30 minutes.

Among other things, measurement was made in exactly the same manner as in the Example 1.

In this way, 8 thermoelectric apparatuses were produced and the lowest temperatures attained thereby were measured under a vacuum of $10^{-5}$ Torr. The result is shown in Table 5 below.

8

Table 5

| No. | Lowest temp. attained (°C) | |
|---|---|---|
| 11 | -39 | |
| 12 | -38 | |
| 13 | -38 | |
| 14 | -38 | |
| 15 | -36 | |
| 16 | -37 | |
| 17 | -37 | |
| 18 | -36 | Average -37.4°C |

The apparatuses were joined to the corresponding constant temperature plates of 27°C with 47°C solder and measured as in the Example 1.

It will be seen that although the lowest temperatures attained changed from -36°C to -39°C, they were within the average value of ±1.5°C.

Furthermore, these 8 thermoelectric apparatuses were electrified alternately by changing the polarities in the air so as to repeat a cycle of cooling and heating as in the Example 1. The result is shown in Table 6 below.

Table 6

| No | Lowest temp. attained (°C) | |
|---|---|---|
| 11 | -39 | |
| 12 | -37 | |
| 13 | -38 | |
| 14 | -39 | |
| 15 | -36 | |
| 16 | -37 | |
| 17 | -37 | |
| 18 | -36 | Average -37.4°C |

As is apparent from the result of Table 6, no deterioration in the characteristic of the thermoelectric apparatuses caused by the freeze of condensed moisture that entered the gap was recognized.

The thermoelectric apparatus thus formed was of high reliability because the solder had a coating thickness prescribable with high accuracy, as well as was spread with high flatness. In addition, the heat exchange substrates and the electrode patterns were joined together closely with high pattern accuracy.

The thermoelectric apparatuses can be provided on various clean packages by soldering without flux since the back surface of the heat exchange substrate includes a gold plated layer.

While the alumina ceramics substrate was used as the insulating substrate in the examples as described above, a beryllia ceramics or aluminum nitride ceramics substrate may be used as well. If a silicon carbide ceramics substrate is used, the heat exchange efficiency greatly increases, no thermal distortion will happen and high reliability is ensured because the heat exchange substrate of silicon carbide ceramics has nine times as high thermal conductivity as the alumina ceramics substrate as well as a small coefficient of thermal expansion.

The electrode patterns are not limited to those of the examples, and the coating thickness is changeable properly.

Since a side of the copper plated layer is exposed in the electrode pattern of the surface in the examples as described above, the following processes may be added to cover the electrode pattern of the surface with a tin plated layer 25f.

That is, after completion of the process shown in FIG. 4(j), a dry film was stuck to the back surface and patterned by photolithography to form a resist pattern R3, as shown in FIG. 5(a).

After that, the electroless tin plating was made, as shown in FIG. 5(b), the surface of the copper plated layer that was exposed at the side of the surface electrode pattern is covered with the tin plated layer 25f, and the resist pattern R3 was removed.

Although a tin layer was also formed on the solder layer of the surface of the electrode pattern, it had only a slight thickness.

While in the above example the copper layer, the nickel layer, and the gold layer were formed, and the solder plated layer was then formed, the nickel layer and the gold layer are changeable properly or can be omitted.

For comparison, the thermoelectric apparatuses were fabricated by applying 98Sn-2Sb solder by hand to the sliced elements and performing other remaining steps exactly identical to the corresponding steps performed for fabricating example 2. The lowest temperatures attained by the apparatuses were measured. The result is shown in Table 7 below.

## Table 7

| No | Lowest temp. attained (°C) |
|----|------|
| 31 | -36 |
| 32 | -26 |
| 33 | -10 |
| 34 | -40 |
| 35 | -38 |
| 36 | -35 |

Average -30.8 °C

In this case, the lowest temperatures attained changed widely from -10°C to -40°C, and two of the apparatuses were defective and their lowest temperatures could not be measured.

Furthermore, these 6 thermoelectric apparatuses were electrified alternately by changing the polarities in the air so as to repeat a cycle of cooling and heating as in the Examples 1-3. The result is shown in Table 8 below.

## Table 8

| No | Lowest temp. attained (°C) |
|----|------|
| 31 | -28 |
| 32 | -26 |
| 33 | -10 |
| 34 | -14 |
| 35 | -38 |
| 36 | -36 |

Average -25.5 °C

As is apparent from the result of Table 8, the lowest temperatures attained changed widely and two of the apparatuses could not be cooled due to the freeze of condensed moisture that entered them.

It will be seen from the comparison of the results of the Examples 1-3 with Tables 7 and 8 that thermoelectric apparatuses are made with high yield by the method of the present invention.

While in the examples as described above, both the first and the second heat exchange substrates were made of an alumina ceramics substrate, and the 5-layered electrode thin film pattern that has a solder plated layer thereon was used on each of the substrates, one of them may be constructed by this method and the other may be constructed by other materials using an other electrode forming method. Alternatively, an apparatus may be constructed using only one heat exchange substrate.

Other insulating substrates such as beryllia ceramics, aluminum nitride ceramics, or silicon carbide ceramics substrates may be used in addition to the alumina ceramics substrate according to the method of the present invention.

10

## INDUSTRIAL APPLICABILITY

According to the method of the present invention as described above, when thermoelectric elements of a thermoelectric apparatus are produced, a solder plated layer is formed on each of the surfaces of the P and N type semiconductors that have Peltier effect and the respective semiconductors are cut to required shapes. The solder layer that has a uniform thickness is obtained very easily, and the coating thickness of solder is prescribed with high accuracy and as a result, a reliable thermoelectric apparatus is formed.

## Claims

1.  A method of making a thermoelectric apparatus including at least one thermoelectric element couple disposed through an electrode on a heat exchange substrate, comprising the steps of:
    forming the thermoelectric element couple;
    forming an electrode pattern on a surface of the heat exchange substrate made of an insulating substrate; and
    mounting the thermoelectric element couple on the electrode pattern,
    the step of forming the thermoelectric element couple including the steps of:
    solder plating each surface of a P and an N type semiconductors that have Peltier effect; and
    cutting the respective semiconductors to a required shape to form a P and an N type thermoelectric elements.

2.  A method of making a thermoelectric apparatus as claimed in claim (1), wherein the solder plating step includes the step of forming a solder plated layer having a composition including, as main components, tin (Sn): 70-99.95% and antimony (Sb): 0.05-30% on each surface of the P and N type semiconductors.

3.  A method of making a thermoelectric apparatus as claimed in claim (1), wherein the solder plating step includes the step of forming a solder plated layer having a composition including, as main components, tin (Sn): 10-99.8% and lead(Pb): 0.2-90% on each surface of the P and N type semiconductors.

4.  A method of making a thermoelectric apparatus as claimed in claim (1), wherein the solder plating step includes the step of forming a solder plated layer having a composition including, as main components, tin (Sn): 60-99.9% and copper (Cu): 0.01-40% on each surface of the P and N type semiconductors.

5.  A method of making a thermoelectric apparatus as claimed in claim (1), wherein the solder plating step includes the step of forming a solder plated layer having a composition including, as main components, tin (Sn): 95-99.9% and germanium (Ge): 0.1-5% on each surface of the P and N type semiconductors.

6.  A method of making a thermoelectric apparatus as claimed in claim (1), wherein the solder plating step includes the step of forming a solder plated layer having a composition including, as main components, lead (Pb): 50-95% and indium (In): 5-50% on each surface of the P and N type semiconductors.

**FIG.1**

**FIG.2**

FIG.3(a)

FIG.3(b)

FIG.3(c)

FIG.3(d)

FIG.3(e)

FIG.3(f)

FIG.3(g)

**FIG. 4 (a)** 4a

**FIG. 4 (b)** 25a

**FIG. 4 (c)** R1 R1

**FIG. 4 (d)** 25b

**FIG. 4 (e)** 25c

**FIG. 4 (f)** 25d

**FIG. 4 (g)** R2 25e

**FIG. 4 (h)** R2

**FIG. 4 (i)**

**FIG. 4 (j)**

FIG.5(a)

FIG.5(b)

FIG.6

**FIG.7(a)**

13

**FIG.7(b)**

2
13

**FIG.7(c)**

3S
2
13
3S

**FIG.7(d)**

13
3S

**FIG.7(e)**

11
14

3S
2
13
2
3S

15
12

**FIG.7(f)**

11
14

15
12

# INTERNATIONAL SEARCH REPORT

International Application No  PCT/JP91/00633

**I. CLASSIFICATION OF SUBJECT MATTER** (if several classification symbols apply, indicate all) [6]

According to International Patent Classification (IPC) or to both National Classification and IPC

Int. Cl[5]   H01L35/34

**II. FIELDS SEARCHED**

| Minimum Documentation Searched [7] | |
|---|---|
| Classification System | Classification Symbols |
| IPC | H01L35/00-35/34 |

| Documentation Searched other than Minimum Documentation to the Extent that such Documents are Included in the Fields Searched [8] | |
|---|---|
| Jitsuyo Shinan Koho | 1960 – 1990 |
| Kokai Jitsuyo Shinan Koho | 1971 – 1990 |

**III. DOCUMENTS CONSIDERED TO BE RELEVANT [9]**

| Category [*] | Citation of Document, [11] with indication, where appropriate, of the relevant passages [12] | Relevant to Claim No. [13] |
|---|---|---|
| A | JP, A, 58-64075 (Citizen Watch Co., Ltd.), April 16, 1983 (16. 04. 83), (Family: none) | 1 |
| A | JP, U, 63-20465 (Komatsu Electronics Inc .), February 10, 1988 (10. 02. 88) | 1 |
| A | JP, U, 63-29966 (Komatsu Electronics Inc..), February 27, 1988 (27. 02. 88) | 1 |
| E | JP, A, 2-271683 (Matsushita Electric Ind. Co., Ltd.), November 6, 1990 (06. 11. 90), (Family: none) | 1-6 |

\* Special categories of cited documents: [10]

"A"  document defining the general state of the art which is not considered to be of particular relevance

"E"  earlier document but published on or after the international filing date

"L"  document which may throw doubts on priority claim(s) or which is cited to establish the publication date of another citation or other special reason (as specified)

"O"  document referring to an oral disclosure, use, exhibition or other means

"P"  document published prior to the international filing date but later than the priority date claimed

"T"  later document published after the international filing date or priority date and not in conflict with the application but cited to understand the principle or theory underlying the invention

"X"  document of particular relevance; the claimed invention cannot be considered novel or cannot be considered to involve an inventive step

"Y"  document of particular relevance; the claimed invention cannot be considered to involve an inventive step when the document is combined with one or more other such documents, such combination being obvious to a person skilled in the art

"&"  document member of the same patent family

**IV. CERTIFICATION**

| Date of the Actual Completion of the International Search | Date of Mailing of this International Search Report |
|---|---|
| July 10, 1991 (10. 07. 91) | July 29, 1991 (29. 07. 91) |
| International Searching Authority | Signature of Authorized Officer |
| Japanese Patent Office | |